Europäisches Patentamt

European Patent Office

Office européen des brevets

(19)

(11) Veröffentlichungsnummer: **0 006 119**
**B1**

(12) **EUROPÄISCHE PATENTSCHRIFT**

(45) Veröffentlichungstag der Patentschrift: 01.06.83

(21) Anmeldenummer: **79101352.7**

(22) Anmeldetag: **03.05.79**

(51) Int. Cl.³: **H 01 L 27/06,**
**H 01 L 29/80,**
**H 01 L 21/82,**
**H 01 L 21/265**

(54) Integrierter Sperrschicht-Feldeffekt-Transistor und Verfahren zu dessen Herstellung.

(30) Priorität: **13.06.78 US 915337**

(43) Veröffentlichungstag der Anmeldung:
**09.01.80 Patentblatt 80/1**

(45) Bekanntmachung des Hinweises auf die Patenterteilung:
**01.06.83 Patentblatt 83/22**

(84) Benannte Vertragsstaaten:
**DE FR GB**

(56) Entgegenhaltungen:
**US - A - 4 016 595**
**US - A - 4 066 917**
**US - A - 4 085 417**
**US - A - 4 095 252**

**IEEE TRANSACTIONS ON ELECTRON DEVICES, Band 23, September 1976, New York, US, J. A. PORTER: "JFET—transistor yields device with negative resistance", Seiten 1098—1099**
**IBM TECHNICAL DISCLOSURE BULLETIN, Band 17, August 1974, New York, US, S. K. WIEDMANN: "Hybrid flip flop", Seiten 897—898**

(73) Patentinhaber: **International Business Machines Corporation**
**Armonk, N.Y. 10504 (US)**

(72) Erfinder: **Bergeron, David Leo**
**21 Dufresne Drive**
**Winooski Vermont 05404 (US)**
Erfinder: **Stephens, Geoffrey Brownell**
**1320 Yubinaranda Circle**
**Cary North Carolina 27511 (US)**

(74) Vertreter: **Gaugel, Heinz, Dipl.-Ing.**
**Schönaicher Strasse 220**
**D-7030 Böblingen (DE)**

(56) Entgegenhaltungen:
**IBM TECHNICAL DISCLOSURE BULLETIN, Band 15, Februar 1973, New York, US, S. C. LEWIS et al.: "Single device cell using vertical junction fet", Seite 2822**

# Integrierter Sperrschicht- Feldeffekt-Transistor und Verfahren zu dessen Herstellung

Die Erfindung bezieht sich auf einen integrierten Sperrschicht-Feldeffekt-Transistor und ein Verfahren zu dessen Herstellung, der hinsichtlich seiner Ausbildung und Herstellung verträglich mit auf demselben Halbleiterplättchen angeordneten Bipolar-Transistoren ist, wobei in einer normalerweise als Kollektorzone eines lateralen Bipolar-Transistors vorgesehenen Halbleiterzone eines ersten Leitungstyps eine Sourcezone und lateral dazu eine Drainzone des entgegengesetzten zweiten Leitungstyps angeordnet sind und ein die Source- und Drainzone verbindende Kanalzone des zweiten Leitungstyps in die Halbleiterzone des ersten Leitungstyps implantiert ist, die als Gatezone des Sperrschicht-Feldeffekt-Transistors dient.

Ein derartiger Sperrschicht-Feldeffekt-Transistor ist aus US—A—4 066 917 bekannt.

Bei den bekannten Verfahren zur gleichzeitigen Herstellung von Sperrschicht-Feldeffekt-Transistoren und NPN-Bipolar-Transistoren auf demselben Halbleiterplättchen unter Anwendung derselben Halbleiterprozesse dient eine N-Epitaxieschicht als N-Kanalzone. Außerdem dienen P$^+$-Basiszonen als Gatezone und N$^+$-Anschlußzonen als Source- und Drainzonen. Die Nachteile der in dieser Weise verwirklichten Strukturen liegen in einer relativ geringen Intergrationsdichte und in einer verbesserungsbedürftigen Leistungsfähigkeit. Der Grund dafür liegt darin, daß die N-Epitaxieschicht mit ihren großen Toleranzen in Dicke und spezifischem Widerstand die Eigenschaften des Sperrschicht-Feldeffekt-Transistors bestimmt.

In der Zeitschrift "IEEE International Solid State Circuit Conference, Digest of Technical Papers", 1977, ist unter dem Titel "A Fast 1024-Bit Bipolar RAM Using JFET Load Devices" auf den Seiten 70, 71 und 238 die Herstellung einer N-Epitaxieschicht auf einem P-Substrat beschrieben, wobei in der N-Epitaxieschicht abgesenkte Oxid-Isolationszonen gebildet werden, die bis in das Substrat reichen. Der durchzuführende Oxidationsprozeß führt an der Substratoberfläche zu einer Verringerung der Bor-P-Dotierung, so daß sich längs der Bodenfläche der abgesenkten Oxidzonen ein N-Kanal ausbildet, der die Kanalzone des Sperrschicht-Feldeffekt-Transistors darstellt. Dieses Verfahren läßt eine Kontrolle über die Leitfähigkeitseigenschaften des Feldeffekt-Transistors nicht zu. Außerdem kann der auf diese Weise hergestellte Sperrschicht-Feldeffekt-Transistor nicht als Schalter verwendet werden, da die gesamte Epitaxieschicht selbst als Gatezone wirkt, die nicht mit der erforderlich hohen Geschwindigkeit, wie sie bei einer Anwendung in logischen Schaltungen üblich ist, umschaltbar ist.

Außerdem ist in der Zeitschrift "Solid State Electronics", 1975, Vol. 18, auf den Seiten 937 und 941, unter dem Titel "Gate Modulated Bipolar Transistor" eine Struktur mit einem Sperrschicht-Feldeffekttransistor (JFET) und einem mit diesem verschmolzenen Bipolar-Transistor beschrieben. Dabei bildet der Kollektor des PNP-Transistors gleichzeitig die Gatezone des JFET's. Durch Betrieb des Basis-Kollektorüberganges in Sperrichtung wird des Basistrom in der bei einem JFET üblichen Weise unterdrückt, wobei die N-Epitaxieschicht als Kanalzone wirkt. Nachteilig ist auch hier, daß die Eigenschaften des JFET's von den Schwankungen der Epitaxieschicht in ihrer Dicke und in ihrem Dotierungspegel abhängen. Der auf diese Weise hergestellte Sperrschicht-Feldeffekt-Transistor kann lediglich als Element einer bistabilen Schaltung werdendet werden und nicht als aktiver logischer Schaltkreis. Auch die erreichbare Packungsdichte entspricht nicht der angestrebten Höhe.

Hier will die Erfindung Abhilfe schaffen. Die Erfindung, wie sie in den Ansprüchen gekennzeichnet, ist, löst die Aufgabe, einen Sperrschicht-Feldeffekt-Transistor und ein Verfahren zu dessen Herstellung anzugeben, der unter Anwendung bestehender bipolarer Halbleiterprozesse die Erzielung einer hohen Integrationsdichte gewährleistet und eine Verschmelzung mit gleichzeitig hergestellten Bipolar-Transistoren zuläßt.

Die durch die Erfindung erreichten Vorteile sind im wesentlichen darin zu sehen, daß ein Sperrschicht-Feldeffekt-Transistor erzielt wird, der hinsichtlich seines Platzbedarfes und seiner Eigenschaften außerordentlich vorteilhaft ist und gleichzeitig mit ebenfalls gute Eigenschaften aufweisenden NPN- oder PNP-Bipolar-Transistoren herstellbar ist. Der Sperrschicht-Feldeffekt-Transistor eignet sich als Schaltelement und als aktives Lastelement in einer bipolaren logischen Schaltung. Der Feldeffekt-Transistor ist mit einem Bipolar-Transistor verschmelzbar; die dabei gegenüber herkömmlichen Strukturen erzielte Platzersparnis liegt über 30 %.

Die Erfindung wird im folgenden anhand der Zeichnungen näher erläutert.

Es zeigen:

Fig. 1 das Dotierungsprofil eine NPN-Transistors nach einem Prozeß, wie er in der amerikanischen Patentschnitt 4 110 126 anhand der Fig. 3l beschrieben ist,

Fig. 2A die Schnittansicht eines konventionellen Sperrschicht-Feldeffekt-Transistors (JFET) vor der Implantation der Kanalzone, wobei sich die dargestellte Struktur von der in Fig. 3l der bereits erwähnten amerikanischen Patentschrift gezeigten NPN-Transistorstruktur lediglich dadurch unterscheidet, daß die Kollektorzone 38 fehlt und die Basiszone 40 ausgedehnt ist, bis sie die N$^+$-Zone 56 einschließt,

Fig. 2B eine Schnittansicht der Struktur nach

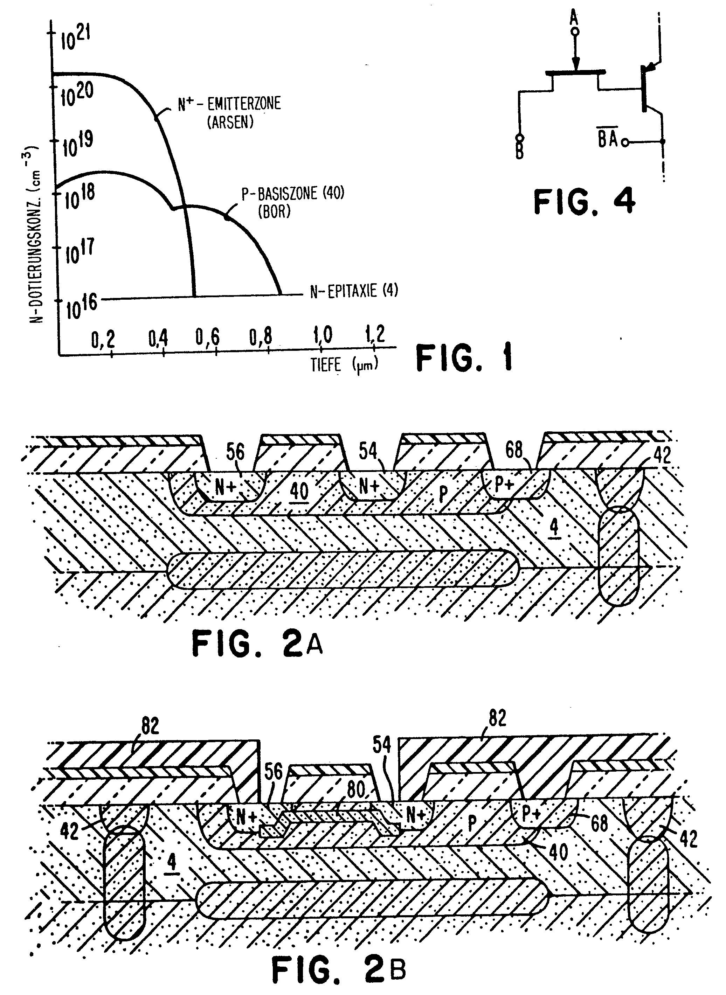

Fig. 2A nach der Implantation der Kanalzone
80,

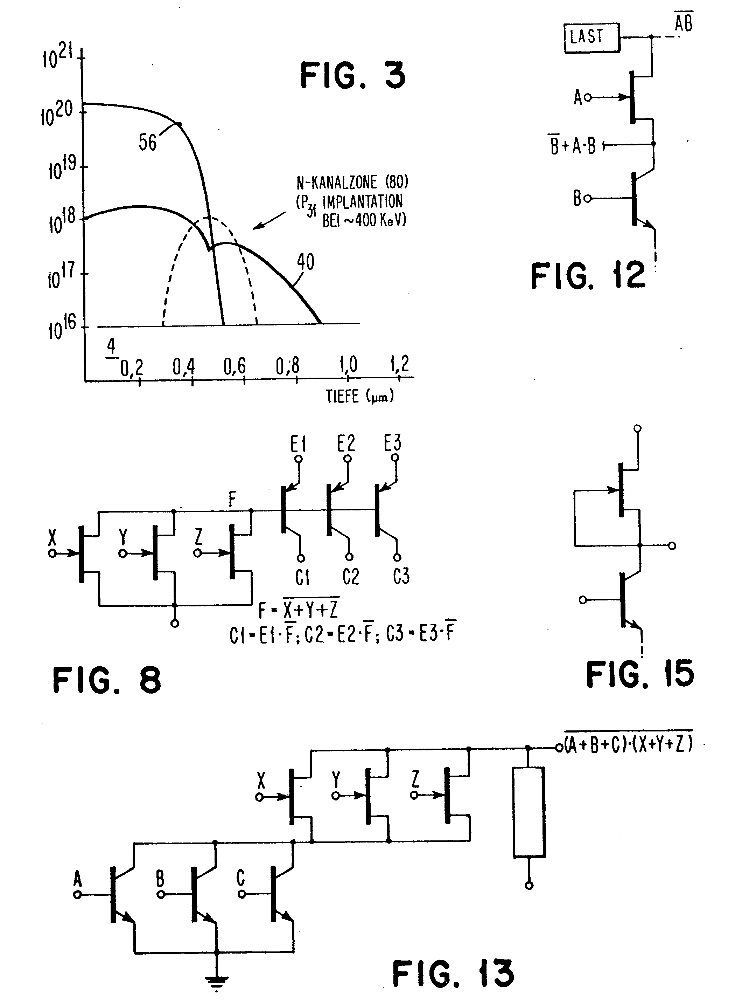

Fig. 3 das Dotierungsprofil der Struktur nach
Fig. 2B mit der N-Kanalzone 80 in der Basiszone 40 des NPN-Transistors,

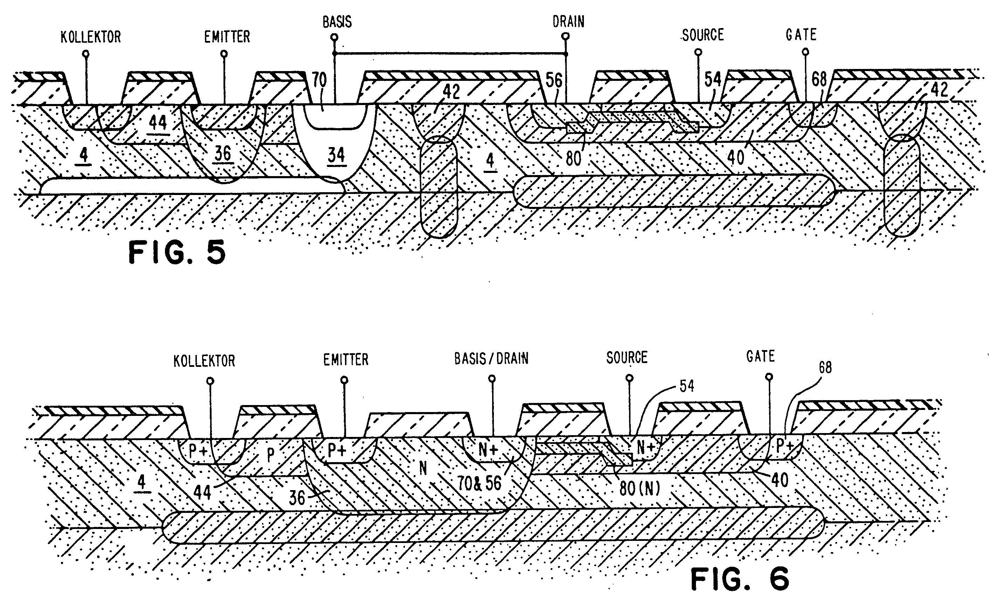

Fig. 4 das Ersatzschaltbild einer verschmolzenen PNP-/JFET-Struktur, die eine NAND-
Schaltung bildet,

Fig. 5 die Schnittansicht eines konventionellen, doppeltdiffundierten PNP-Transistors
und eines N-Kanal-Sperrschicht-Feldeffekt-
Transistors nach Fig. 2B,

Fig. 6 Schnittansicht einer PNP-JFET-Struktur gemäß der Erfindung mit einer Kombination
der gemeinsamen N-Epitaxiebereiche der Basiszone des PNP-Transistors und der Drainzone
des JFET's, wobei die Drainzone aus einer tiefen N-Zone 36 besteht,

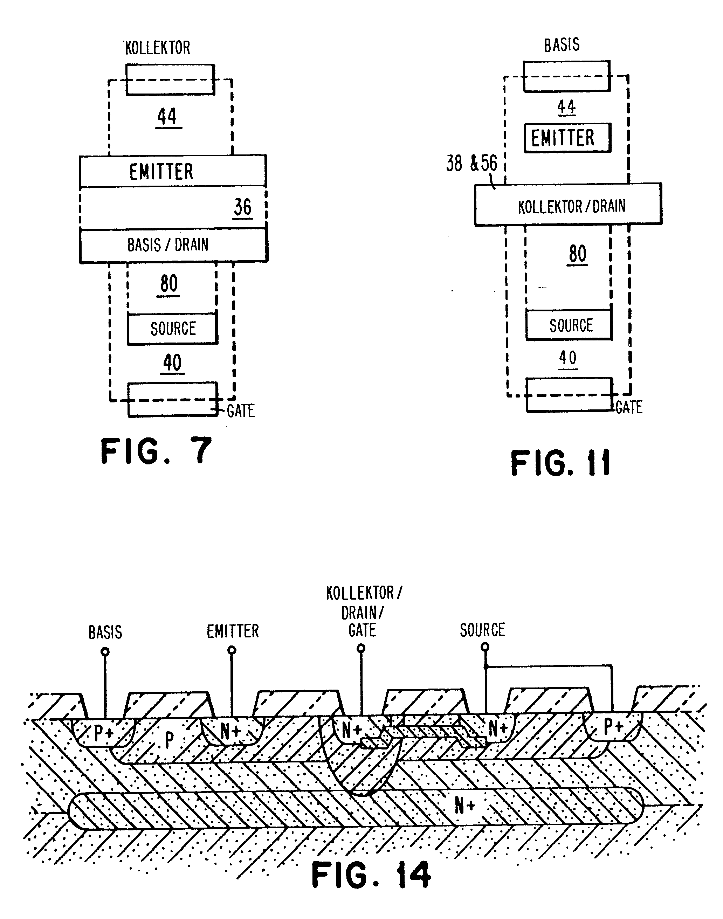

Fig. 7 eine Draufsicht der in Fig. 6 gezeigten
Struktur,

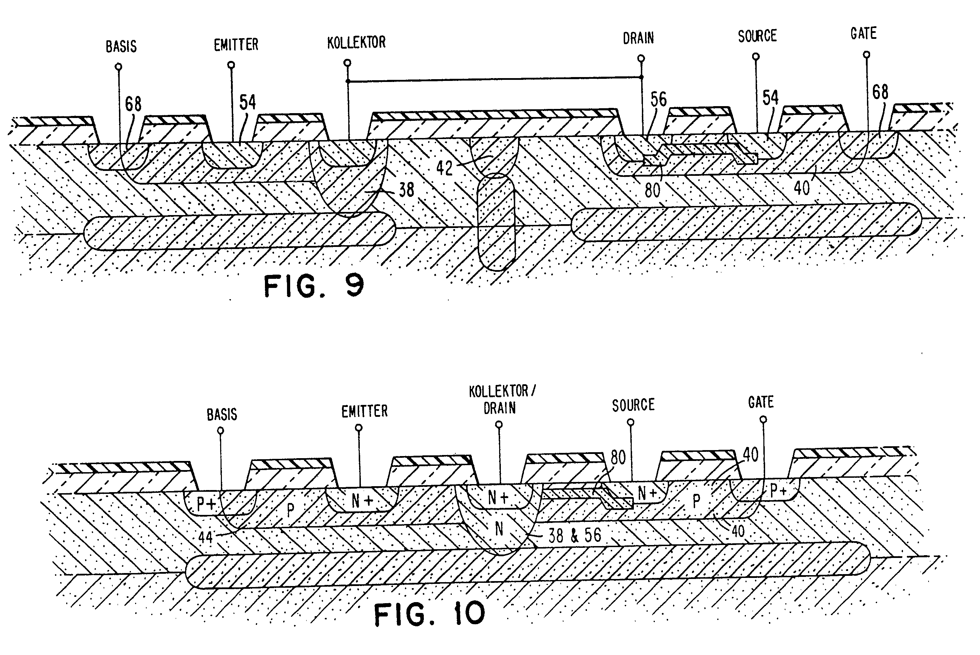

Fig. 8 das elektrische Ersatzschaltbild einer
logischen Schaltung mit mehrfachen JFET-
Strukturen und/oder mehrfachen PNP-Strukturen,

Fig. 9 die Schnittansicht eines konventionellen NPN-Transistors und eines N-Kanal-
Sperrschicht-Feldeffekt-Transistors, wobei der
NPN-Transistor nach dem in den Fign. 3A bis 3I
der bereits erwähnten amerikanischen Patentschrift unter Weglassen der Verbindungszone
38 und der JFET entsprechend der vorliegenden Fig. 2B hergestellt ist,

Fig. 10 die Schnittansicht einer verschmolzenen NPN/JFET-Struktur gemäß der Erfindung, wobei die Verbindungszone 38 gleichzeitig als Kollektorzone des NPN-Transistors
und als Drainzone des JFET's dient,

Fig. 11 die Draufsicht des Struktur nach Fig.
10,

Fig. 12 das Ersatzschaltbild der verschmolzenen NPN/JFET-Struktur, die eine NAND-
Funktion oder andere komplexe logische Funktionen ausführt,

Fig. 13 das elektrische Ersatzschaltbild einer
Struktur, bei der mehr als ein JFET und/oder
mehr als ein Bipolar-Transistor in paralleler
Anordnung zur Durchführung komplexer
logischer Funktionen herangezogen wird,

Fig. 14 die Schnittansicht eines erfindungs
gemäßen JFET's als variablem Lastelement in
der Verschmelzung mit einem NPN-Transistor
und

Fig. 15 das elektrische Ersatzschaltbild eines
JFET's als Lastelement eines PNP-Transistors.

Bei bekannten Methoden, in denen die
JFET's und die Bipolar-Transistoren mit denselben Prozeßschritten hergestellt werden, wird
die N-Epitaxieschicht als Kanalzone verwendet;
dabei dienen die P$^+$-Basiszonen als Gate und
die N$^+$-Anschlußzonen als Source- und Drainzonen.

Mit dieser Methode erhält man Strukturen,
die hinsichtlich ihrer Größe und ihrer Eigenschaften Nachteile aufweisen. Die Ursache
dafür liegt in den die Dicke und den specifischen Widerstand der N-Epitaxieschicht betreffenden großen Toleranten. Die Dicke und der
spezfische Wiederstand sind für die Eigenschaften der Sperrschicht-Feldeffekt-Transistoren von übergeordneter Bedeutung.

Beim erfindungsgemäßen Verfahren werden
unter anderem die Vorteile einer doppelten
Borimplantation ausgenutzt, indem die P-Basiszone im Vergleich zu den einfachen Bipolar-Prozessen durch Ionenimplantation definiert wird.
Auf diese Weise ist es möglich, mit einem
zusätzlichen Maskierungs- und Implantationsschritt hochwertige JFET's mit kontrollierbaren
Eigenschaften zu gewinnen. Die einzelnen
Prozeßschritte selbst sind konventioneller Art.
Die Basis- und Emitterstruktur kann in üblicher
Diffusion- und Markierungstechnik verwirklicht
werden, eine bessere Kontrolle der JFET-Strukturen erreicht man aber, wenn die Basis-
Emitter-Struktur implantiert wird.

Die Fig. 1 zeigt das Dotierungsprofil einer
implantierten Basis-Emitter-Struktur nach vollständig abgeschlossenen Verfahren. Die in Fig.
2A dargestellte NPN-Transistorstruktur einspricht der Struktur gemäß Fig. 3I der bereits
erwähnten amerikanischen Patentschrift wobei
lediglich der Unterschied besteht daß bei der
Struktur gemäß Fig. 2A die Kollektor/Drain-
Diffusion 38 (Fig. 10) fehlt und die Basiszone
40 so ausgedehnt ist, daß sie die N$^+$-Zone 56
einschließt. Die N$^+$-Zonen 56 und 54 in der
Struktur nach Fig. 2A bilden die Drain- und
Sourcezonen der JFET-Struktur. Die P-Zone 40
bildet das Gate des JFET's und die P$^+$-Zone 68
den Gateanschluß.

Der Fig. 2B ist zu entnehmen, wie durch eine
Maskierungsschicht 82 aus Photolack und
einem Implantationsschritt die Kanalzone 80
des JFET's gebildet wird. Bei der Implantation
muß die Kalanzone 80 lediglich an die N$^+$-
Zonen 56 und 54 angelagert werden, die, da sie
die Drain- und Sourcezone bilden, die Kanallänge definieren. Die Kanalbreite wird durch die
Maskierungsschicht 82 bestimmt. Aus der Fig.
3 ist das Konzentrationsprofil des JFET's zu
entnehmen, wobei die N-Kanalzone beispielsweise für eine Phophorimplantation bei etwa
400 Kev und geringer Dosis herausgestellt ist.
Die Dosis bestimmt, wie weit die P-Basiszone
40 durch die Implantation kompensiert wird,
was ausschlaggebend ist für die Schwellenspannung des JFET's. Wie aus der Fig. 3 zu
ersehen ist, liegt das Maximum der Phosphorimplantation im Bereich zwischen der
beiden Maximas der doppelten Borimplantation, durch die die Basiszone 40 des NPN-Transistors difiniert wurde. Die auf diese Weise
erzielte Struktur zeichnet sich durch relativ einfach kontrollierbare Eigenschaften aus, wobei
die Grenzen in der Einstellung der Dosis und
Energie liegen, die bei der Implantation der P-Basiszone und der N-Kanalzone aufgewendet werden.

Die sehr dichte Anordnung vieler JFET's ist möglich, da diese in einer gemeinsamen N-Epitaxieschicht 4 verwirklicht werden.

Die beschriebene JFET-Struktur und das Verfahren zur Herstellung dieser Struktur sind mit NPN- und PNP-Transistoren bester Qualität verträglich. Der JFET kann als Schaltelement oder als aktives Lastelement in einer bipolaren logischen Schaltung verwendet werden. Dabei wird er in einer eigentlich für einen NPN-Transistor vorgesehenen P-Basiszone verwirklicht. Der JFET kann in einer Bipolar/FET-Struktur (BIFET) verschmolzen werden, die eine extrem dichte, zur Durchführung einer zweistufigen logischen Funktion geeignete Schaltung bilden. In der verschmolzenen BIFET-Struktur haben der JFET und der Bipolar-Transistor gemeinsame Elemente, so daß die Anzahl der erforderlichen Kontaktfenster und die erforderliche Halbleiterfläche reduziert wird. BIFET-Strukturen sind sowohl mit NPN-Transistoren als auch mit PNP-Transistoren herstellbar. Die Flächeneinsparung gegenüber nicht verschmolzenen JFET- und Bipolarstrukturen beträgt mehr als 30 %.

Wie das Ersatzchaltbild in Fig. 4 zeigt, kann mit der Kombination eines PNP-Transistors und eines JFET eine logische NAND-Schaltung mit den Eingängen A und B gebildet werden. Eine konventionelle Implementierung dieser logischen Schaltung ist in der Schnittansicht der Fig. 5 dargestellt, wo der PNP-Transistor in der durch die Fign. 3A bis 3I der bereits erwähnten amerikansichen Patentanmeldung gezeigten Weise hergestellt ist. Die verwendete JFEt-Struktur entspricht der in Fig. 2B gezeigten Struktur. Durch Kombinieren der gemeinsamen N-Epitaxieschichten 4, der Basisanschlußzonen 70, 34 und der Drainzone 56 kann der Flächenbedarf der logischen Schaltung um etwa 30 % reduziert werden. Eine Schnittansicht einer gemäß der Erfindung verschmolzenen Struktur ist in Fig. 6 dargestellt. Dabei bildet die N-Zone 36 die Basiszone des PNP-Transistors und die Drainzone des JFET's. Die Tiefe in N-Zone 36 kann als Drainzone verwendet werden, da sie gegenüber der flacheren $N^+$-Sourcezone 54 durch die P-Gatezone 40 automatisch selbst ausgerichtet und isoliert ist. Die Draufsicht der Struktur ist in Fig. 7 dargestellt. Die Kanalzone 80 wird von der P-Gatezone 40, der Drain- bzw. Basiskontaktzone 36 und der Sourcezone 54 begrenzt. Dieses Konzept läßt sich so erweitern, daß zur Durchführung komplexer logischer Funktionen geeignete Strukturen mit Vielfach-JFET's und/oder Vielfach-PNP-Transistoren entstehen. Für diesen Zweck wird das in Fig. 7 gezeigte Layout in vertikaler Richtung in einer gemeinsamen Epitaxieschicht wiederholt. Das Ersatzschaltbid einer solchen Struktur ist in Fig. 8 dargestellt. Der gemeinsame Knoten F entspricht der gemeinsamen Epitaxieschicht.

Das aufgezeigte Prinzip kann auch durch Verschmelzen der Drainzone mit der Kollektorzone eines NPN-Transistors verwirklicht werden. Dabei ergibt sich eine logische Schaltung, wie sie in Fig. 12 dargestellt ist. Eine konventionelle Implementation dieser logischen Schaltung ist in Schnittansicht in Fig. 9 dargestellt. Die struktur des PNP-Transistors von Fig. 9 ist wiederum entsprechend den Angaben in der bereits erwähnten amerikanischen Patentschrift ausgebildet. Der in der Fig. 9 verwendete JFET entspricht dem der Fig. 2B. Kombiniert man die Kollektorverbindungszone 38 so, daß sie gleichzeitig die Kollektorzone des NPN-Transistors und die Drain des JFET's bildet, so kann der Flächenbedarf der auf diese Weise gebildeten logischen Schaltung um etwa 34 % reduziert werden. Eine entsprechende erfindungs gemäße Struktur ist in Fig. 10 in Schnittansicht und in Fig. 11 in Draufsicht dargestellt. Die Ursache der Verminderung des Flächenbedarf liegt im Wegfall einer separaten Drainzone 56 und einer Isolationszone 42 mit dem diese umgebenden Bereich der Epitaxieschicht.

Durch Kombinationen der aufgezeigten Anordnungen lassen sich verschiedenste logische Funktionen verwirklichen, wobei eine beträchtliche Einsparung an Halbleiterfläche erzielt wird.

In der Fig. 13 ist das elektrische Ersatzschaltbild mehrerer erfindungsgemäß verschmolzener NPN/JFET-Strukturen dargestellt.

Weiterhin kann der erfindungsgemäße JFET als variables Lastelement in Verschmelzung mit einem NPN-Transistor verwendet werden. Dabei wird das Gate mit der verschmolzenen Kollektor/Drainzone elektrisch verbunden. Eine entsprechende Anordnung ist in Schnittansicht in Fig. 14 und im Ersatzschaltbild in Fig. 15 dargestellt. Der JFET wird nicht leitend, wenn die Kollektorzone des NPN-Transistors auf tiefem Potential liegt (leitender Transistor). Der JFET ist leitend, wenn die Kollektorzone des NPN-Transistors auf hohem Potential liegt (nichtleitender Transistor).

In seiner Anwendung als aktives Lastelement in einer bipolaren logischen Schaltung stellt der JFET einen steuerbaren Widerstand dar, der bei einem minimalen Mehraufwand im Herstellungsverfahren eine beträchtliche Verminderung der Verlustleistung gewährleistet.

Die verschmolzene JFET/Bipolar-Struktur gestattet die Verwirklichung extrem dichter logischer Schaltungen, wenn der JFET als Schalter verwendet wird. Verglichen mit Strukturen ohne die erfindungsgemäße Verschmelzung ergibt sich eine Verminderung des Flächenbedarfs um 30 % bei JFET/PNP-Strukturen und eine solche von 34 % bei JFET/NPN-Strukturen. Die JFET/Bipolar-Struktur läßt sich zu einer Vielfach-Struktur erweitern, mit der sich komplexe logische Funktionen darstellen lassen.

## Patentansprüche

1. Integrierter Sperrschicht - Feldeffekt-Transistor, der hinsichtlich seiner Ausbildung und Herstellung verträglich mit auf demselben Halbleiterplättchen angeordenten Bipolar-Transistoren ist, wobei in einer normalerweise als Kollektorzone eines lateralen Bipolar-Transistors vorgesehenen Halbleiterzone (40, 44) eines ersten Leitungstyps eine Sourcezone (54) und lateral dazu eine Drainzone (56) des entgegengesetzten zweiten Leitungstyps angeordnet sind und eine die Source- und Drainzone (54, 56) verbindende Kanalzone (80) des zweiten Leitungstyps in die Halbleiterzone (40) des ersten Leitungstyps implantiert ist, die als Gatezone des Sperrschicht-Feldeffekt-Transistors dient, durch gekennzeichnet, daß die Halbleiterzone (40) des ersten Leitungstyps entweder als Basiszone eines vertikalen oder als Kolektorzone eines Lateralen Bipolar-Transistors dient und daß die Drainzone (36, 56, 70; 56, 38) diese Halbleiterzone (40) durchdringt und sie dabei in einen ersten (40), den Sperrschicht-Feldeffekt-Transistor und in einen zweiten (44), den Bipolar-Transistor enthaltenden Bereich isolierend unterteilt.

2. Integrierter Sperrschicht - Feldeffekt-Transistor nach Anspruch 1, dadurch gekennzeichnet, daß der die Sourcezone (54) und die Kanalzone (80) enthaltende erste Bereich als Gatezone des Sperrschicht-Feldeffekt-Transistors dient und daß in den zweiten Bereich eine Emitterzone des zweiten Leitungytyps eines vertikalen Bipolar-Transistors eingebracht ist, dessen Kollektorzone (38) durch die Drainzone (56) und dessen Basiszone durch den zweiten Bereich der Halbleiterzone (44) gebildet ist (Fig. 10).

3. Integrierter Sperrschicht - Felkeffekt-Transistor nach Anspruch 2, dadurch gekennzeichnet, daß die Gatezone (40) mit der Drain/Kollektorzone (38, 56) leitend verbunden ist, so daß der Sperrschicht-Feldeffekt-Transistor das Lastelement des Bipolar-Transistors bildet.

4. Integrierter Sperrschicht - Feldeffekt-Transistor nach Anspruch 1, dadurch gekennzeichnet, daß der die Sourcezone (54) und die Kanalzone (80) enthaltende erste Bereich als Gatezone des Sperrschicht-Feldeffekt-Transistors dient und daß in die Drainzone (36, 56, 70) eine Emitterzone des ersten Leitungstyps eines lateralen Bipolar-Transistors eingebracht ist, dessen Basiszone (70) durch die Drainzone (36, 56, 70) und dessen Kollketorzone durch den zweiten Bereich (44) der Halbleiterzone gebildet ist.

5. Verfahren zur Herstellung des Sperrschicht-Feldeffekt-Transistors nach einem der Ansprüche 1 bis 4, dadurch gekennzeichnet, daß im Zuge der Herstellung von Bipolar-Transistoren nach dem Einbringen von als Basiszonen von vertikalen oder als Kollektorzone von lateralen Bipolar-Transistoren dienenden Halbleiterzonen (40, 44) eines ersten Leitungstyps in eine Halbleiterschicht (4) eines zweiten Leitungstyps auf mindestens eine der Halbleiterzonen (40, 44) eine Maskierungsschicht aufgebracht wird, daß im Bereich eines ersten Maskenfensters die Drainzone (56) des zweiten Leitungstyps und im Bereich eines zweiten Maskenfensters die Sourcezone (54) des zweiten Leitungstyps eines Sperrschicht-Feldeffekt-Transistors eingebracht werden und daß schließlich eine die Drainzone (56) mit der Sourcezone (54) verbindende Kanalzone (80) des zweiten Leitungstyps in die Halbleiterzone (40) implantiert wird.

6. Verfahren nach Anspruch 5, zur Herstellung eines Sperrschicht-Feldeffekt-Transistors nach Anspruch 2, dadurch gekennzeichnet, daß nach dem Einbringen der als Basiszone eines vertikalen Bipolar-Transistors dienenden Halbleiterzone (40, 44) im Bereich des ersten Maskenfensters die Drainzone (56), im Bereich des zweiten Maskenfensters die Sourcezone (54) und im Bereich eines zusätzlichen dritten Maskenfensters die Emitterzone des Bipolar-Transistors in den zweiten Bereich (44) der Halbleiterzone eingebracht wird (Fig. 10).

7. Verfahren nach Anspruch 5, zur Herstellung eines Sperrschicht-Feldeffekt-Transistors nach Anspruch 4, dadurch gekenzeichnet, daß nach dem Einbringen der als Kollektorzone eines lateralen Bipolar-Transistors dienenden Halbleiterzone (40, 44) im Bereich des ersten Maskenfensters die Drainzone (56), im Bereich des zweiten Maskenfensters die Sourcezone (54) und im Bereich eines dritten Maskenfensters in die Drainzone (36, 56, 70), die Emitterzone des Bipolar-Transistors eingebracht wird (Fig. 6).

## Revendications

1. Transistor intégré à effet de champ à grille isolée, qui, de par sa conception et sa fabrication, est compatible avec des transistors bipolaires disposés sur la même plaquette de semi-conducteurs, sur laquelle sont installées une zone source (54), normalement placée dans une zone de semi-conducteurs (40, 44), prévue comme zone de collecteur d'un transistor bipolaire latéral d'un premier type de conductivité et transversalement à la zone source, une zone de drain (56) du second type de conductivité, opposé audit premier type; une zone de canal (80) du second type de conductivité reliant la zone source (54) à la zone de drain (56) est implantée dans la zone de semi-conducteurs (49) du premier type de conductivité; cette zone de canal sert de zone de grille au transistor à effet de champ à grille isolée, caractérisé en ce que la zone de semi-conducteurs (40) du premier type de conductivité sert, soit de zone de base à un transistor bipolaire vertical, soit de zone de collecteur à un transistor bipolaire transversal et que la zone de drain (36, 56, 70, 56, 38) traverse cette zone de semi-conducteurs (40) en la divisant, par isolement, en une première région (40) comportant le transistor à effet de champ à grille isolée et une seconde région (44) comportant le transistor bipolaire.

2. Transistor intégré à effet de champ à grille isolée suivant la revendication 1, caractérisé en ce que la première région contenant la zone source (54) et la zone canal (80) sert de zone de grille au transistor à effet de champ à grille isolée et que dans la seconde région est disposée une zone d'émetteur du second type de conductivité pour un transistor bipolare vertical dont la zone de collecteur (38) est formée par la zone drain (56), et la zone de base par la deuxième région (44) de la zone de semi-conducteurs (figure 10).

3. Transistor intégré à effet de champ à grille isolée suivant la revendication 2, caractérisé en ce que la zone de grille (40) est reliée électriquement à la zone de drain/collecteur (38, 56), si bien que le transistor à effet de champ à grille isolée forme l'élément de charge du transistor bipolaire.

4. Transistor intégré à effet de champ à grille isolée suivant la revendication 1, caractérisé en ce que la première région contenant la zone source (54) et la zone de canal (80) sert de zone de grille pour le transistor à effet de champ à grille isolée et qu'une zone d'émetteur du premier type de conduction d'un transistor bipolaire transversal, dont la zone de base (70) est formée par la zone de drain (36, 56, 70) et la zone de collecteur par la seconde région (44) de la zone de semi-conducteurs, est appliquée dans la zone du drain (36, 56, 70).

5. Procédé pour la fabrication d'un transistor à effet de champ à grille isolée suivant l'une des revendications 1 à 4, caractérisé en ce que au cours de la fabrication de transistors bipolaires, après dépôt de la zone de semi-conducteurs (40, 44), servant de zone de base à des transistors bipolaires verticaux ou de zone de base à des transistors bipolaires verticaux ou de zone de collecteur de transistors bipolaires latéraux, d'un premier type de conductivité dans une couche de semi-conducteurs (4) d'un second type de conduction, au moins sur l'une des régions de semi-conducteurs (40, 44) sera revêtue d'une couche de masquage; dans la région d'une première fenêtre de masquage sera appliquée la zone de drain (56) du second type de conductivité, et dans la région d'une deuxième fenêtre du masque la zone source (54) du second type de conductivité d'un transistor à effet de champ à grille isolée et, enfin, une zone de canal (80) du second type de conduction, reliant la zone de drain (56) à la zone source (54) sera implantée dans la zone de semi-conducteurs (40).

6. Procédé suivant la revendication 5 pour la réalisation d'un transistor à effet de champ suivant la revendication 2, caractérisé en ce que après dépôt de la zone de semi-conducteurs (40, 44) servent de zone de base d'un transistor bipolaire vertical, la zone de drain (56) sera apposée dan la région de la première fenêtre du masque, la zone source (54) dans la région de la deuxième fenêtre du masque et la zone d'émetteur du transistor bipolaire, dans la deuxième région (44) de la zone de semi-conducteurs (figure 10), est appliquée dans la région d'une troisième fenêtre supplémentaire du masque.

7. Procédé suivant la revendication 5 pour la réalisation d'un transistor à effet de champ à grille isolée suivant la revendication 4, caractérisé en ce que après dépôt de la zone de semi-conducteurs (40, 44) servant de zone de collecteur d'un transistor bipolaire latéral, la zone de drain (56) du transistor bipolaire est appliquée dans la région de la première fenêtre du masque, la zone source (54) dans la région de la deuxième fenêtre du masque et la zone d'émetteur du transistor bipolaire (figure 6) est appliquée dans la région d'une troisième fenêtre du masque, dans la zone de drain (36, 56, 70).

**Claims**

1. Integrated barrier layer field effect transistor which with respect to its design and production is arranged compatible with bipolar transistors on the same semiconductor wafer, where in a semiconductor zone (40A, 44) of a first conductivity type which usually is provided as the collector region of a lateral bipolar transistor a source region (54) and laterally thereto a drain region (56) of the opposite second conductivity type are arranged and where a channel region (80) of the second conductivity type connecting the source and drain regions (54, 56) is implanted in the semiconductor zone (40) of the first conductivity type which serves as the gate region of the barrier layer field effect transistor, characterized in that the semiconductor region (40) of the first conductivity type serves either as a base region of a vertical, or as a collector region of a lateral bipolar transistor, and in that the drain region (36, 56, 70; 56, 38) permeates this semiconductor region (40), dividing it in the manner of an insulation into a first (40) zone containing the barrier layer field effect transistor, and into a second (44) zone containing the bipolar transistor.

2. Integrated barrier layer field effect transistor as claimed in claim 1, characterized in that the first zone containing the source region (54) and the channel region (80) is used as the gate region of the barrer layer field effect transistor, and that inserted into the second zone an emitter region of the second conductivity type of a vertical bipolar transistor is provided whose collector region (38) is represented by the drain region (56), and whose base region is represented by the second zone of the semiconductor region (44) (Fig. 10).

3. Integrated barrier layer field effect transistor as claimed in claim 2, characterized in that the gate region (40) is conductively connected to the drain/collector region (38, 56) so that the barrier layer field effect transistor forms the load element at the bipolar transistor.

4. Integrated barrier layer field effect transistor as claimed in claim 1, characterized in that the first zone containing the source region (54) and the channel region (80) is used as the gate region of the barrier layer field effect transistor, and that inserted into the drain region (36, 56, 70) an emitter region of the first conductivity type of lateral bipolar transistor is provided whose base region (70) is represented by the drain region (36, 56, 70), and whose collector region is represented by the second zone (44) of the semiconductor region.

5. Method of making the barrier layer field effect transistor as claimed in any one of claims 1 to 4, characterized in that in the course of the production of bipolar transistors, following the insertion of semiconductor regions (40A, 44) of a first conductivity type which serve as base regions of vertical bipolar transistors, or as collector region of lateral bipolar transistors, into a semiconductor layer (4) of a second conductivity type a masking layer is provided on at least one of the semiconductor regions (40A, 44), that in the region of a first mask window the drain region (56) of the second conductivity type, and in the region of a second mask window the source region (54) of the second conductivity type of a barrier layer field effect transistor are introduced, and that finally a channel region (80) of the second conductivity type connecting the drain region (56) to the source region (54) is implanted in the semiconductor region (40).

6. Method as claimed in claim 5 for making a barrier layer field effect transistor as claimed in claim 2, characterized in that after the inserting of the semiconductor region (40A, 44) serving as a base region of a vertical bipolar transistor the drain region (56) within the region of the first mask window, the source region (54) within the region of the second mask window, and the emitter region of the bipolar transistor within the region of an additional third mask window is inserted in the second region of the semiconductor region (Fig. 10).

7. Method as claimed in claim 5 for making a barrier layer field effect transistor as claimed in claim 4, characterized in that after the inserting of the semiconductor region (40A, 44) serving as the collector region of a lateral bipolar transistor the drain region (56) within the region of the first mask window, the source region (54) within the region of the second mask window, and the emitter region of the bipolar transistor (Fig. 6) within the region of a third mask window are implanted in the drain region (36, 56, 70).

FIG. 1

FIG. 4

FIG. 2A

FIG. 2B

FIG. 3

N-KANALZONE (80)
($P_{31}$ IMPLANTATION BEI ~400 KeV)

TIEFE (μm)

FIG. 12

FIG. 8

$F = \overline{X+Y+Z}$
$C1 = E1 \cdot \overline{F}; C2 = E2 \cdot \overline{F}; C3 = E3 \cdot \overline{F}$

FIG. 15

$\overline{(A+B+C)\cdot(X+Y+Z)}$

FIG. 13

2

FIG. 5

KOLLEKTOR    EMITTER    BASIS    DRAIN    SOURCE    GATE

70    42    56    54    68    42
44    36    34    4    80    40
4

FIG. 6

KOLLEKTOR    EMITTER    BASIS/DRAIN    SOURCE    GATE    68
54
P+    P    P+    N+    N+    P+
4    44    36    N    70&56    80(N)    40

0006119

3

KOLLEKTOR

**44**

EMITTER

**36**

BASIS / DRAIN

**80**

SOURCE

**40**

GATE

# FIG. 7

BASIS

**44**

EMITTER

38 &56

KOLLEKTOR / DRAIN

**80**

SOURCE

**40**

GATE

# FIG. 11

KOLLEKTOR /
DRAIN /
GATE

BASIS     EMITTER          SOURCE

P+    P    N+     N+     N+    P+

N+

# FIG. 14

4

BASIS    EMITTER    KOLLEKTOR    DRAIN    SOURCE    GATE

68   54   56   54   68

42   38   80   40

FIG. 9

BASIS    EMITTER    KOLLEKTOR / DRAIN    SOURCE    GATE

P+   P   N+   N+   80   N+   P   40   P+

44   N   38 & 56   40

FIG. 10

0006119

5